# EUROPÄISCHE PATENTANMELDUNG

(11) **EP 4 403 254 A1**
(43) Veröffentlichungstag der Anmeldung: **24.07.2024**
(21) Anmeldenummer: 23219861.4
(22) Anmeldetag: 22.12.2023
(51) Int. Cl.: B01J 3/03, C23C 14/56

(54) **SCHLEUSENVORRICHTUNG UND VERFAHREN ZU DEREN BETRIEB**

(30) Priorität: 18.01.2023 DE 102023200340
(71) Anmelder: SMS Group GmbH, 40237 Düsseldorf (DE)
(72) Erfinder: Artel, Jens, 57399 Kirchhundem (DE); Roth, Ingmar, 57258 Freudenberg (DE); Scheffe, Kurt, 57271 Hilchenbach (DE); Kümmel, Lutz, 41363 Jüchen (DE); Daube, Thomas, 47279 Duisburg (DE); Dorstewitz, Frank, 46242 Bottrop (DE); Steffen, Knoblauch, 57223 Kreuztal (DE)
(74) Vertreter: Klüppel, Walter

(57) **Zusammenfassung**

Die Erfindung betrifft eine Schleusenvorrichtung 100 und ein Verfahren zum kontinuierlichen Ein- und Ausschleusen von vorzugsweise metallischem Bandmaterial 20 in einen bzw. aus einem Bandbehandlungsbereich 220. Zu diesem Zweck weist die Schleusenvorrichtung 100 eine äußere und eine innere Druckkammer 110, 120 auf, wobei der Außendruck p1 in der äußeren Druckkammer 110 größer ist als der Innendruck p2 in der inneren Druckkammer 120. Beide Druckkammern sind ausgebildet zur Aufnahme eines Fluids 142. Darüber hinaus ist eine fluidleitende Verbindung 140 für das Fluid 142 zwischen den beiden Druckkammern 110, 120 vorgesehen. Um den Leckagevolumenstrom bei einer derartigen Schleusenvorrichtung und deren Bauhöhe gegenüber dem Stand der Technik zu verringern, sind bei der erfindungsgemäßen Schleusenvorrichtung ein unteres Trennelement 150-u und ein oberes Trennelement 150-o vorgesehen zum Trennen der beiden Druckkammern 110, 120 voneinander, wobei zwischen den beiden Trennelementen ein Fenster 152 ausgebildet ist zum Durchleiten des Bandmaterials 20. In der fluidleitenden Verbindung ist eine Fluidpumpe 145 eingebaut zum Pumpen von zumindest Teilen des Fluids 142, soweit es von Leckagevolumenströmen gebildet ist, von der inneren Druckkammer 120 zurück in die äußere Druckkammer 110.

## Beschreibung

Die Erfindung betrifft eine Schleusenvorrichtung und ein Verfahren zum kontinuierlichen Ein- und Ausschleusen von Bandmaterial, vorzugsweise metallischem Bandmaterial in einen bzw. aus einem Bandbehandlungsbereich. Weiterhin betrifft die Erfindung eine Bandbehandlungsanlage mit einer Eingangs- und einer Ausgangsschleuse für das Bandmaterial sowie ein Verfahren zum Betreiben einer derartigen Bandbehandlungsanlage.

Im Stand der Technik sind verschiedene Schleusentypen bekannt; insbesondere werden Gasschleusen und Siphonschleusen unterschieden.

Bei reinen Gasschleusen wird das Bandmaterial durch eine Dichtebene von einer ersten in eine zweite Druckkammer geführt. Die Dichtebene hat aus unterschiedlichen Gründen Leckagen durch die Gas von der ersten in die zweite Druckkammer strömt oder umgekehrt, je nachdem in welcher Druckkammer der Druck größer ist. Ein derartiger Leckagevolumenstrom des Gases ist unerwünscht, weil er zu einem Ausgleich der unterschiedlichen Drücke in den Druckkammern führt. Bei nur kleinen Leckagen könnten die Leistungsanforderungen an die Vakuumpumpen, die die Druckdifferenz zwischen den beiden Druckkammern aufrechterhalten, reduziert werden. Es ist bekannt, die Dichtebenen in Form von Abquetschrollen, umschlingenden Rollen mit gegenüberliegender einseitiger Dichtlippe zum Bandmaterial oder mit beidseitigen Dichtlippen auf dem Band auszuführen. Zudem sind mechanische Anstellelemente bekannt, um Spaltbereiche, die aufgrund von variabler Bandgeometrie, insbesondere variabler Bandbreite des Bandmaterials entstehen, abzudichten. Neben dem besagten Nachteil des Leckagevolumenstroms durch die unvermeidlichen Spaltbereiche in der Dichtebene besteht ein weiterer Nachteil bei den bekannten Gasschleusen darin, dass das Gas in den Druckkammern der Gasschleusen beim Absenken des Druckes expandiert, wodurch das Verhältnis der Drücke in den beiden Druckkammern der Gasschleuse limitiert ist. Daher sind Gasschleusen, abhängig von der Qualität des Vakuums, d. h. von der Möglichkeit zur Aufrechterhaltung des Unterdruckes in den einzelnen Druckkammern, mehrstufig ausgeführt.

Ein Beispiel für eine Siphonschleuse ist z. B. offenbart in der deutschen Patentanmeldung DE 10 2017 223 778 A. Bei Siphonschleusen gibt es typischerweise eine innere und eine äußere Druckkammer, in denen jeweils unterschiedliche Drücke eingestellt sind. Die beiden Druckkammern sind zur Aufnahme eines Fluids dicht ausgebildet und bilden aufgrund der sie verbindenden offenen fluidleitenden Verbindung mit dem in beiden Druckkammern befindlichen Fluid ein Gebilde in Form von sogenannten kommunizierenden Röhren. Der Druckunterschied in den beiden Druckkammern wird traditionell durch den hydrostatischen Druck des Fluids in den beiden Druckkammern hergestellt. Das Fluid bildet im Stand der Technik quasi die Dichtebene zwischen den beiden Druckkammern. Das Fluid als Dichtebene hat - anders als bei den besagten Gasschleusen - keine Spaltbereiche und deshalb haben Siphonschleusen zumindest theoretisch eine deutlich höhere Dichtigkeit als Gasschleusen. Da bei Siphonschleusen die Druckdifferenz zwischen den Drücken in den beiden Druckkammern durch die hydrostatische Druckdifferenz in der Flüssigkeitssäule erreicht wird, können je nach verwendetem Fluid und zu erreichender Druckdifferenz sehr große Bauhöhen von mehreren Metern erforderlich sein. Durch den Wegfall von weiteren Dichtelementen sind Siphonschleusen sehr einfach aufgebaut.

Der Erfindung liegt die Aufgabe zugrunde, eine bekannte Schleusenvorrichtung, ein bekanntes Verfahren zu deren Betrieb sowie eine bekannte Bandbehandlungsanlage und ein bekanntes Verfahren zu deren Betrieb dahingehend weiterzubilden, dass der Leckagevolumenstrom bei gleichzeitig verringerter Bauhöhe gegenüber dem Stand der Technik verringert wird.

Diese Aufgabe wird durch die in Patentanspruch 1 beanspruchte Schleusenvorrichtung gelöst. Diese Schleusenvorrichtung ist dadurch gekennzeichnet, dass ein unteres Trennelement vorgesehen ist zum Trennen der äußeren von der inneren Druckkammer bis auf einen Leckagespalt, dass zwischen dem oberen und dem unteren Trennelement ein Fenster ausgebildet ist zum Durchleiten des Bandmaterials und dass in der fluidleitenden Verbindung eine Pumpe eingebaut ist zum Pumpen von zumindest Teilen des Fluids von der inneren Druckkammer durch die fluidleitende Verbindung zurück in die äußere Druckkammer.

Die Begriffe "Innen" und "Außen" beziehen sich auf eine Bandbehandlungsanlage mit einer zentralen Bandbehandlungskammer, in die/aus der das zu behandelnde Bandmaterial mit Hilfe der erfindungsgemäßen Schleusenvorrichtung eingeschleust und/oder ausgeschleust werden kann. Der Begriff "Innen" symbolisiert eine Nähe zu oder eine Identität mit der Behandlungskammer während der Begriff "Außen" eine größere Entfernung von dem Zentrum der Bandbehandlungsanlage bzw. insbesondere der Bandbehandlungskammer meint.

Das Bandmaterial kann metallisch oder aus einem beliebigen anderen, auch nichtmetallischem Werkstoff, beispielsweise Kunststoff gebildet sein.

Leckagespalte treten auf zwischen dem freien Ende eines der Trennelemente und einer Rolle oder der Oberfläche des Bandmaterials auf der sie enden. Ein Leckagespalt tritt auch auf zwischen einer Rolle und dem an der Rolle anliegenden Bandmaterial. Seitliche Spaltbereiche treten auf bei Zwischenräumen zwischen der Wand einer Druckkammer und entweder der Stirnseite einer Rolle oder der Schmalseite des Bandmaterials, auch wenn diese Zwischenräume von den Trennelementen oder speziellen Blenden abgedeckt sind. Diese Abdeckungen sind in der Regel nicht wirklich dicht und deshalb verbleiben an den Rändern die seitlichen Spaltbereiche als Leckagespalt.

Leckagespalte bzw. seitliche Spaltbereiche sind konstruktiv nicht bewusst vorgesehen oder geplant, vielmehr sind die Trennelemente, vorzugsweise mit Dichtlippen, und eventuell auch die Blenden so ausgelegt, dass die Leckagespalte und seitlichen Spaltbereiche möglichst gar nicht auftreten, zumindest aber möglichst klein bleiben. Trotzdem sind die Leckagespalte bei Betrieb der Schleusenvorrichtung oftmals unvermeidlich, insbesondere dort, wo feststehende und bewegliche Teile eng benachbart sind.

Durch das beanspruchte untere Trennelement wird ein Austausch des Fluids zwischen der äußeren und der inneren Druckkammer der Schleusenvorrichtung grundsätzlich wirkungsvoll verhindert. Der Austausch des Fluids zwischen den Druckkammern ist grundsätzlich auch nicht durch die fluidleitende Verbindung möglich, solange die darin eingebaute Pumpe ausgeschaltet ist. Ein Austausch des Fluids zwischen den beiden Druckkammern ist auch nicht - außer durch unvermeidliche Leckageverluste - durch das beanspruchte Fenster möglich, denn während des Betriebs der Schleusenvorrichtung wird das Fenster bis auf einen unvermeidlichen Leckagespalt oder mehrere Leckagespalte oder seitliche Spaltbereiche durch das durchgeleitete Bandmaterial verschlossen. Insofern stellt sich eine Druckdifferenz zwischen der inneren und der äußeren Druckkammer bei der erfindungsgemäßen Schleusenvorrichtung im Unterschied zu einer bekannten Siphonschleuse nicht auf Basis von Hydrostatik, sondern aufgrund der Drosselwirkung in dem unvermeidlichen Leckagespalt oder seitlichen Spaltbereich ein. Dadurch ist es vorteilhafterweise möglich, die äußere und die innere Druckkammer bei der erfindungsgemäßen Schleusenvorrichtung auch bei großen Unterschieden zwischen dem Außendruck in der äußeren Druckkammer und dem Innendruck in der inneren Druckkammer im Vergleich zu einer hydrostatischen Siphonschleuse mit deutlich geringerer Bauhöhe zu realisieren.

Der sich durch den gefluteten Leckagespalt oder die seitlichen Spaltbereiche einstellende Leckagevolumenstrom des Fluids ist aufgrund der im Vergleich zu einem Gas signifikant höheren Viskosität des Fluids deutlich kleiner als bei den bekannten Gasschleusen. Zudem ist das Fluid nahezu inkompressibel, so dass auch eine druckabhängige Expansion des Fluids praktisch nicht stattfindet. Die Pumpe in der fluidleitenden Verbindung wird erfindungsgemäß genutzt, um den bei Betrieb der Schleusenvorrichtung von der äußeren Druckkammer mit dem höheren Druck in die innere Druckkammer mit dem niedrigeren Druck strömenden Leckagevolumenstrom des Fluids von der inneren Druckkammer wieder zurück in die äußere Druckkammer zu pumpen. Je größer das Druckverhältnis zwischen dem äußeren Druck und dem inneren Druck ist, desto größer ist der Leckagevolumenstrom und desto mehr Volumen muss die Pumpe in der fluidleitenden Verbindung pumpen.

Für den Betrieb der erfindungsgemäßen Schleusenvorrichtung wird die äußere Druckkammer zumindest soweit geflutet, dass ein unterer Leckagespalt zwischen der Unterseite des Metallbandes oder einer Rolle an der Unterseite des Metallbandes und dem unteren Trennelement überflutet wird. Dadurch wird sichergestellt, dass kein Gas, sondern allenfalls das Fluid von der äußeren Druckkammer in die innere Druckkammer strömen kann. Die Pumpe in der fluidleitenden Verbindung muss lediglich so ausgelegt sein, dass sie den durch den Leckagespalt fließenden Leckagevolumenstrom des Fluids ausgleichen, d. h in die äußere Druckkammer zurückpumpen kann. Aufgrund der besagten signifikant höheren Viskosität des Fluids gegenüber einem Gas ist der Leckagevolumenstrom entsprechend deutlich geringer und dementsprechend braucht auch die Pumpe in der fluidleitenden Verbindung nur für geringere Leistungen ausgelegt zu sein; Pumpen mit einer geringeren Leistung sind typischerweise auch billiger als Pumpen mit einer höheren Leistungsfähigkeit.

Gemäß ersten Ausführungsbeispielen kann die fluidleitende Verbindung in Form einer Öffnung oder eines Kanalabschnittes, d. h. z. B. eines kurzen Schlauch- oder Rohrstückes direkt in dem unteren Trennelement ausgebildet sein. Zusätzlich oder alternativ dazu kann die fluidleitende Verbindung auch in Form eines Bypasses außerhalb der beiden Druckkammern verlaufend ausgebildet sein. Die Ausbildung als Bypass bietet den Vorteil, dass die in der fluidleitenden Verbindung eingebaute Pumpe im Falle einer notwendigen Reparatur oder eines Austausches einfacher zugänglich ist, als wenn die Pumpe in dem unteren Trennelement eingebaut wäre.

An dem rollenseitigen oder bandmaterialseitigen Ende des oberen und/oder des unteren Trennelementes kann eine vorzugsweise elastische Dichtlippe angeordnet sein zum dichtenden Kontaktieren der Rolle oder des Bandmaterials bis auf einen unvermeidlichen Leckagespalt. Der Leckagespalt ist bei der vorliegenden Erfindung akzeptabel, weil, wie gesagt, der durch den Leckagespalt hindurchströmende Leckagevolumenstrom des Fluids von der Pumpe in der fluidleitenden Verbindung von der inneren Druckkammer wieder in die äußere Druckkammer zurückgepumpt wird. Insofern kann von einer absolut dichtenden Anlage des Dichtelementes an der Rolle oder dem durchlaufenden Bandmaterial abgesehen werden. Das bietet gegenüber im Stand der Technik ebenfalls bekannten mechanisch abdichtenden Schleusen den Vorteil, dass der Verschleiß der Dichtlippe geringer ist und dass außerdem die Oberfläche des Bandmaterials geschont, d. h. z. B. nicht verkratzt wird. Außerdem verhindert der Leckagespalt mit dem durchströmenden Fluid eine Erwärmung der Dichtlippe durch Reibung an dem Bandmaterial. Abgesehen von möglichen Rollen in dem Fenster zwischen dem oberen und dem unteren Trennelement können Rollen in der äußeren und/oder in der inneren Druckkammer auch vorgesehen sein zum Umlenken oder Stabilisieren des Bandmaterials während seines Durchlaufs durch die Druckkammern in Durchlaufrichtung vor und/oder hinter der Trennebene.

Für die Produktion kann es einfacher sein, das obere und das untere Trennelement mit dem darin befindlichen Fenster nicht separat, sondern einstückig auszubilden.

Der Öffnungsquerschnitt des Fensters zwischen dem oberen und dem unteren Trennelement ist bei der erfindungsgemäßen Schleusenvorrichtung zumindest entsprechend dem Querschnitt des durchzuleitenden Bandmaterials zu wählen, damit das Bandmaterial durch das Fenster geleitet werden kann. Ist in dem Fenster zusätzlich eine obere und/oder untere Rolle vorgesehen zum Führen des Bandes bei Durchleitung durch das Fenster, so sind die Querschnitte dieser mindesteines einen Rolle zusätzlich zu dem die Rolle kontaktierenden Bandmaterial zu berücksichtigen. In der Praxis schließt der Öffnungsquerschnitt des Fensters bei der vorliegenden Erfindung Leckagespalte mit ein.

Die oben genannte Aufgabe der Erfindung wird weiterhin durch ein Verfahren gemäß Anspruch 12 zum Betreiben der Schleusenvorrichtung gelöst. Die Vorteile dieses Verfahrens entsprechen den oben mit Bezug auf die beanspruchte Schleusenvorrichtung genannten Vorteilen.

Darüber hinaus ist es vorteilhaft, dass - wenn die Schleusenvorrichtung als Eingangsschleuse für die Behandlungskammer fungiert - das Bandmaterial nach dem Durchlaufen der äußeren Druckkammer innerhalb der inneren Druckkammer eine Trocknungseinrichtung durchläuft zum Trocknen des noch aus der äußeren Druckkammer an dem Bandmaterial anhaftenden Fluids vor dem Einlaufen in die Behandlungskammer. Für eine nachfolgende Behandlung muss das Bandmaterial typischerweise trocken sein. Zum Trocknen des Bandmaterials kann die Trocknungseinrichtung beispielsweise eine Heizeinrichtung aufweisen zum Verdampfen des noch an dem Bandmaterial anhaftenden Fluids und eine der Heizeinrichtung nachgeordnete Kühlfalle zum anschließenden Kondensieren des verdampften Fluids.

Die oben genannte Aufgabe der Erfindung wird weiterhin durch eine Bandbehandlungsanlage gemäß Anspruch 19 und ein Verfahren zum Betreiben der Bandbehandlungsanlage nach Anspruch 22 gelöst.

Vorteilhafte Ausgestaltungen der beanspruchten Schleusenvorrichtung, des beanspruchten Verfahrens zu deren Betrieb, der beanspruchten Bandbehandlungsanlage sowie des beanspruchten Verfahrens zum Betreiben der Bandbehandlungsanlage sind Gegenstand der abhängigen Ansprüche.

Der Beschreibung sind insgesamt 6 Figuren beigefügt, wobei
- Figur 1: eine Bandbehandlungsanlage mit einem ersten Ausführungsbeispiel für die erfindungsgemäße Schleusenvorrichtung als Eingangs- und Ausgangsschleuse;
- Figur 1a: die Bandbehandlungsanlage nach Figur 1 mit einer Variante zur Ausbildung einer fluidleitenden Verbindung;
- Figur 2: eine Ansicht des Fensters zwischen dem oberen und dem unteren Trennelement bei dem ersten Ausführungsbeispiel der Schleusenvorrichtung gemäß Figur 1;
- Figur 3: die erfindungsgemäße Bandbehandlungsanlage mit einem zweiten Ausführungsbeispiel für die erfindungsgemäße Schleusenvorrichtung als Eingangs- und Ausgangsschleuse;
- Figur 4: eine Ansicht des Fensters zwischen dem oberen und der unteren Trennelement bei dem zweiten Ausführungsbeispiel der erfindungsgemäßen Schleusenvorrichtung;
- Figur 5: eine erfindungsgemäße Bandbehandlungsanlage mit einem dritten Ausführungsbeispiel für die erfindungsgemäße Schleusenvorrichtung als Eingangs- und Ausgangsschleuse; und
- Figur 6: eine Ansicht des Fensters zwischen dem oberen und dem unteren Trennelement bei dem dritten Ausführungsbeispiel der erfindungsgemäßen Schleusenvorrichtung gemäß Figur 5
zeigt.

Die Erfindung wird nachfolgend unter Bezugnahme auf die genannten Figuren in Form von Ausführungsbeispielen detailliert beschrieben. In allen Figuren sind gleiche technische Elemente mit gleichen Bezugszeichen bezeichnet.

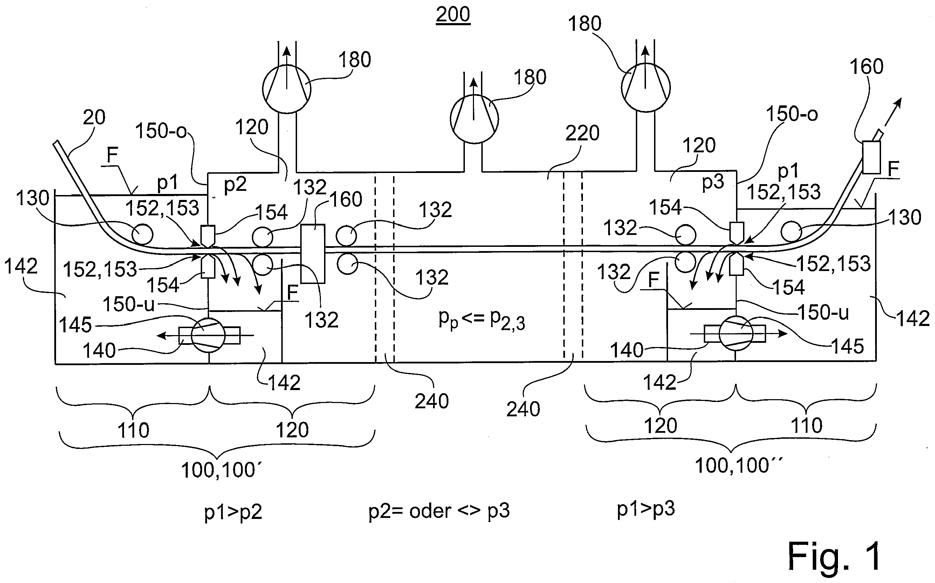

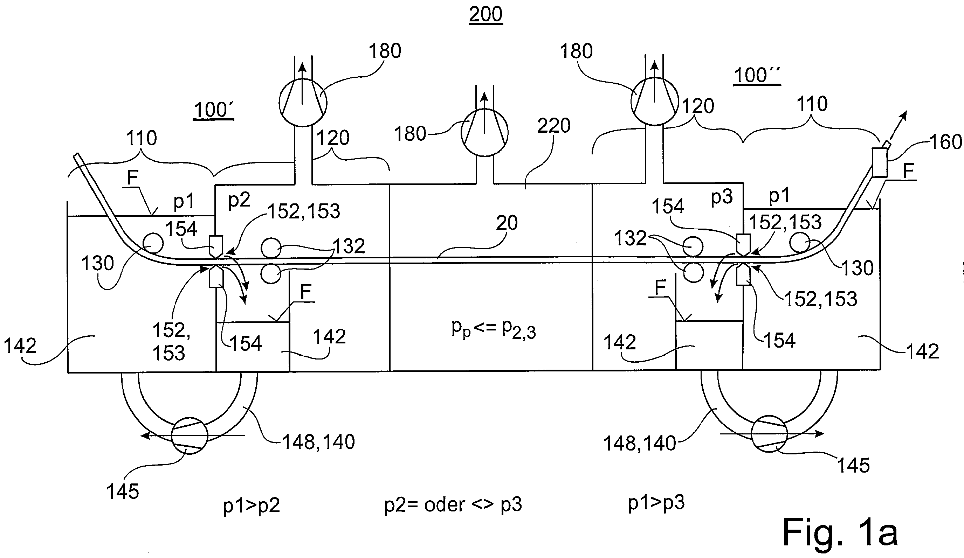

Figur 1 zeigt eine Bandbehandlungsanlage 200. Sie besteht aus einer Eingangsschleuse 100` in Form einer erfindungsgemäßen Schleusenvorrichtung 100 und einer Ausgangsschleuse 100", hier beispielhaft ebenfalls in Form der erfindungsgemäßen Schleusenvorrichtung 100 und aus einer zwischen die Eingangsschleuse 100' und die Ausgangsschleuse 100" geschalteten Behandlungskammer 220 zum Behandeln eines durch die Behandlungsanlage 200 in Pfeilrichtung, d. h. hier von links nach rechts hindurchlaufenden vorzugsweise metallischen Bandmaterials 20.

Die Eingangsschleuse 100' umfasst eine äußere Druckkammer 110 und eine innere Druckkammer 120, die über ein oberes Trennelement 150-o und ein unteres Trennelement 150-u voneinander getrennt sind. Das obere Trennelement 150-o trennt die beiden Druckkammern 110, 120 oberhalb des durchzuleitenden Bandmaterials 20 voneinander. Zu diesem Zweck ist an dem bandseitigen Ende des oberen Trennelementes 150-o vorzugsweise eine elastische Dichtlippe 154 angeordnet zum dichtenden Kontaktieren des durchgeleiteten Bandmaterials 20 bis auf einen unvermeidlichen Leckagespalt 153. Analog trennt das untere Trennelement 150-u die innere und die äußere Druckkammer 120, 110 unterhalb des durchgeleiteten Bandmaterials 20 voneinander. Zu diesem Zweck ist an dem oberen bandseitigen Ende des unteren Trennelementes ebenfalls vorzugsweise eine Dichtlippe 154 angeordnet zum dichtenden Kontaktieren der Unterseite des metallischen Bandmaterials 20. Zwischen dem oberen und dem unteren Trennelement 150-o, 150-u ist ein Fenster 152 ausgebildet zum Durchleiten des Bandmaterials 20. Weiterhin ist in dem unteren Trennelement 150-u eine fluidleitende Verbindung 140, hier beispielhaft in Form eines kurzen Kanalabschnittes mit einer Pumpe 145 ausgebildet zum Pumpen von zumindest Teilen eines Fluids von der inneren Druckkammer 120 zurück in die äußere Druckkammer 110. Alternativ zu dem in Figur 1 gezeigten Kanalabschnitt kann die fluidleitende Verbindung 140 auch lediglich in Form einer Öffnung in dem unteren Trennelement 150-u mit der eingebauten Flüssigkeitspumpe 145 ausgebildet sein.

In den Grenzbereichen zwischen den Dichtlippen 154 und dem durchlaufenden Bandmaterial sowie in den seitlichen Spaltbereichen können jeweils unvermeidliche Leckagespalte 153 entstehen.

In der äußeren Druckkammer 110 ist eine Rolle 130 zu erkennen, die hier als Umlenkrolle fungiert zum Umlenken des Bandmaterials 20 innerhalb der äußeren Druckkammer in die Horizontale und auf das Fenster 152 zwischen dem oberen und dem unteren Trennelement hin. In der inneren Druckkammer 120 sind hier beispielhaft zwei Führungsrollenpaare mit jeweils zwei sich gegenüberstehenden Führungsrollen 132 angeordnet. Diese beiden Rollenpaare spannen jeweils einen Rollenspalt auf zum Durchleiten und Stabilisieren des Bandmaterials 20 auf seinem Weg in die nachgeschaltete Behandlungskammer 220. Zwischen den beiden Führungsrollenpaaren ist hier beispielhaft eine Trocknungseinrichtung 160 angeordnet zum Trocknen des noch aus der äußeren Druckkammer 110 an dem Bandmaterial 20 anhaftenden Fluids vor dem Einlaufen des Bandmaterials 20 in die Behandlungskammer 200. Zum Einstellen des Innendrucks p2 in der inneren Druckkammer 120, bei dem es sich typischerweise um einen Unterdruck gegenüber dem Atmosphärendruck p1 in der äußeren Druckkammer 110 handelt, ist eine Vakuumpumpe 180 vorgesehen, die den Innendruck p2 gegenüber dem Atmosphärendruck p1 in der äußeren Druckkammer absenkt.

Die in der Figur 1 ebenfalls gezeigte Ausgangsschleuse 100" ist analog zu der hier zuvor beschriebenen Eingangsschleuse 100' gemäß der vorliegenden Erfindung ausgebildet. Die einzigen Unterschiede bestehen darin, dass der Innendruck p3 in der inneren Druckkammer 120 der Ausgangsschleuse einen anderen Wert haben kann als der Druck p2 in der inneren Druckkammer der Eingangsschleuse 100'. Die beiden Innendrücke p2, p3 können jedoch auch gleich sein. In jedem Fall sollte der Innendruck p3 - genau wie der Innendruck p2 - kleiner sein als der Außendruck in der äußeren Druckkammer 110 der Ausgangsschleuse 100". Als weiterer Unterschied ist festzustellen, dass die innere Druckkammer 120 der Ausgangsschleuse keiner Trocknungseinrichtung bedarf, weil das Bandmaterial 20, wenn es die Behandlungskammer 220 verlässt, typischerweise trocken ist. Innerhalb oder hinter der äußeren Druckkammer 110 der Ausgangsschleuse (100") kann das Bandmaterial 20 mit Hilfe einer weiteren Trocknungseinrichtung 160 getrocknet werden, nachdem es noch angefeuchtet mit dem Fluid 142 aus der Ausgangsschleuse 100" ausgetreten ist.

Das hier in Figur 1 gezeigte Führungsrollenpaar 132 in der inneren Druckkammer 120 der Ausgangsschleuse 100" dient ebenfalls zum Stabilisieren des Bandmaterials 20, bevor dieses in das Fenster 152 zwischen dem oberen Trennelement 150-o und dem unteren Trennelement 150-u einläuft. Die in der äußeren Druckkammer 110 der Ausgangsschleuse 100" gezeigte Umlenkrolle 130 dient zum Umlenken des Bandmaterials aus der äußeren Druckkammer 110 nach Verlassen der durch das obere und das untere Trennelement 150-o, 150-u gebildeten Trennebene zwischen der inneren und der äußeren Druckkammer 120, 110 der Ausgangsschleuse 100". Auch für das Realisieren des Innendruckes p3 in der inneren Druckkammer 120 ist typischerweise eine Vakuumpumpe 180 erforderlich, weil der Innendruck p3 in der Regel kleiner als der Außendruck p1 ist.

Der Innendruck pₚ innerhalb der Behandlungskammer 220 kann gleich, größer, oder kleiner sein als der Innendruck p2 in der inneren Druckkammer 120 der Eingangsschleuse 100` oder als der Innendruck p3 in der inneren Druckkammer 120 der Ausgangsschleuse 100". Wenn alle drei Drücke pₚ, p2 und p3 unterschiedlich sind bedarf es der drei in Figur 1 gezeigten Vakuumpumpen 180 für die drei einzelnen voneinander getrennten Kammern.

Wenn der Innendruck pₚ der Behandlungskammer 220 dem Innendruck p2 der inneren Druckkammer der Eingangsschleuse 120 entspricht, so braucht zwischen diesen beiden Kammern keine weitere Schleuse 240 vorgesehen zu werden und es bedarf auch keiner zusätzlichen Vakuumpumpe zur Einstellung des inneren Druckes pₚ innerhalb der Behandlungskammer 220. Die innere Druckkammer 120 der Eingangsschleuse 100' und die Behandlungskammer 220 können dann einteilig d. h. in Form eines Raumes ausgebildet sein. Analoges gilt, wenn der Innendruck pₚ der Behandlungskammer 220 gleich dem Innendruck p3 der inneren Druckkammer 120 der Ausgangsschleuse 100" ist. Wenn gilt p₂=pₚ=p₃, d. h. dass wenn alle Innendrücke gleich groß sind, dann können die innere Druckkammer 120 der Eingangsschleuse 100', die Behandlungskammer 220 und die innere Druckkammer 120 der Ausgangsschleuse 100" zusammen als ein Raum ausgebildet sein. Es ist dann auch nur eine Vakuumpumpe 180 zum Einstellen des gemeinsamen Druckes erforderlich.

Andererseits ist für den Fall, dass der Innendruck pₚ der Behandlungskammer 220 abweichend sein sollte von dem Innendruck p2 oder von dem Innendruck p₃, in den Übergangsbereichen jeweils eine weitere Schleuse 240 vorzusehen zum Durchleiten des Bandmaterials 20 zwischen den unterschiedlichen Druckbereichen. Außerdem ist gegebenenfalls eine weitere Vakuumpumpe 180 vorzusehen zum alleinigen Einstellen des Druckes pₚ in der Behandlungskammer 220. Die Drücke p₂, pₚ und p₃ liegen typischerweise alle unterhalb des Atmosphärendruckes; insofern handelt es sich jeweils um Unterdrücke, die mit Hilfe der mindestens einen besagten Vakuumpumpe 180 einzustellen sind.

Figur 1a unterscheidet sich von Figur 1 lediglich darin, dass sie eine Variante für die fluidleitende Verbindung 140 in Form eines Bypasses 148 zeigt. Der Bypass 148 ist außerhalb der beiden Druckkammern 110, 120 verlaufend ausgebildet und die Pumpe 145 zum Pumpen von zumindest Teilen des Fluids von der inneren Druckkammer 120 in die äußere Druckkammer 110 ist hier in den Bypass 148 eingebaut. Der Bypass 148 kann alternativ oder zusätzlich zu der Öffnung oder dem Kanalabschnitt in dem unteren Trennelement 150-u ausgebildet sein. Sollte eine dieser Varianten zusätzlich realisiert sein, so ist darauf zu achten, dass auch bei dieser Variante eine Pumpe 145 in die Öffnung oder den Kanalabschnitt eingesetzt ist zum Verhindern von unerwünschtem Fließen des Fluids von der äußeren in die innere Druckkammer 110, 120.

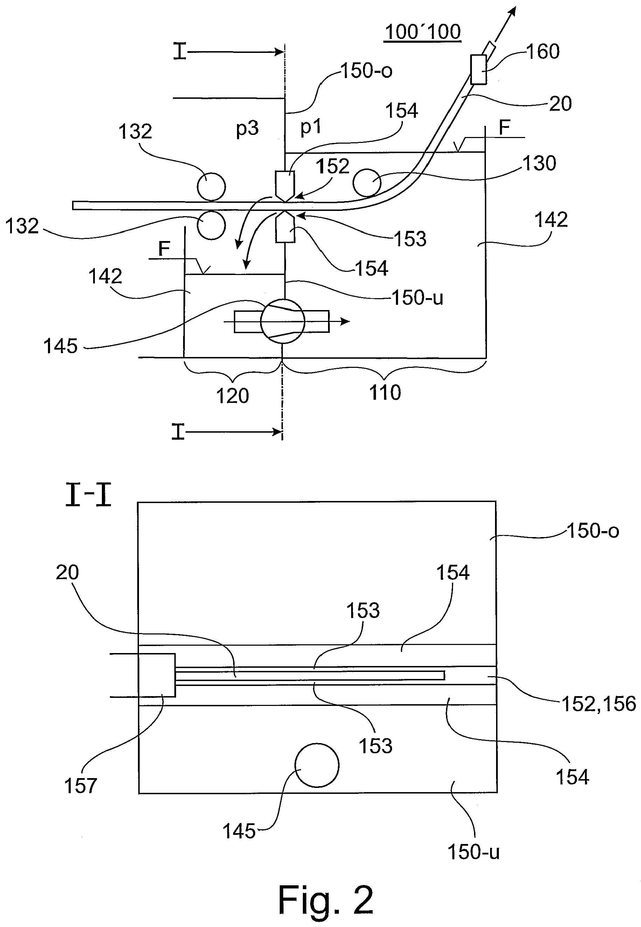

Figur 2 zeigt in ihrer oberen Abbildung noch einmal die Ausgangsschleuse 100' gemäß Figur 1, wobei die Dichtlippe 154 an dem bandseitigen Ende des oberen Trennelementes 150-o an der Oberseite des Bandmaterials 20 endet bis auf einen unvermeidlichen Leckagespalt 153. Analog endet die Dichtlippe 154 des unteren Trennelementes 150-u an der Unterseite des Bandmaterials 20, ebenfalls bis auf einen unvermeidlichen unteren Leckagespalt 153.

Die untere Abbildung in Figur 2 zeigt diese Situation in einer Querschnittsansicht I-I. Neben den Leckagespalten 153 zur Oberseite und zur Unterseite des Bandmaterials 20 zeigt die untere Abbildung, dass auch seitliche Spaltbereiche 156 zwischen den Schmalseiten des Bandmaterials und den Wänden der Druckkammer vorhanden sein können; hier in Figur 2 beispielhaft nur auf der rechten Seite gezeigt. Diese seitlichen Spaltbereiche 156 können - bis auf verbleibende unvermeidliche Leckagespalte 153 - durch das untere Trennelement 150-u oder das obere Trennelement 150-o oder deren zugeordnete Dichtlippen 154 abgedeckt werden, wenn sich diese Trennelemente oder Dichtlippen in vertikaler Richtung über die Höhe des Walzgutes 20 hinaus in die besagten seitlichen Spaltbereiche 156 hinein erstrecken. Alternativ können zum Abdecken der seitlichen Spaltbereiche - ebenfalls bis auf die unvermeidlichen Leckagespalte - auch ein- oder beidseitig verstellbare Blenden 157 vorgesehen sein, hier beispielhaft linksseitig. Die Verstellbarkeit dieser Blenden 157 ermöglicht es vorteilhafterweise, dass sich die Blenden an die in Abhängigkeit der Breite des Bandmaterials 20 variierenden Breiten der seitlichen Spaltbereiche anpassen können.

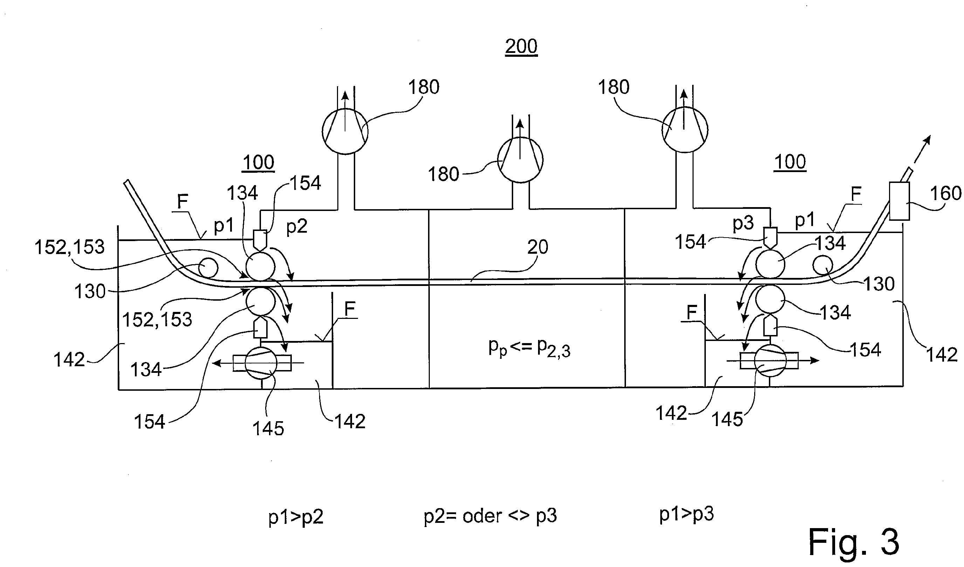

Figur 3 zeigt die erfindungsgemäße Bandbehandlungsanlage 200 mit einem zweiten Ausführungsbeispiel für die erfindungsgemäße Schleusenvorrichtung 100 als Ein- und Ausgangsschleuse 100', 100" für die Behandlungskammer 220. Bei dem ersten Ausführungsbeispiel gemäß Figur 1 enden die Dichtlippen 154 des oberen und des unteren Trennelementes 150-o, 150-u - bis auf die unvermeidlichen Leckagespalte 153 - auf der Oberseite bzw. auf der Unterseite des Bandmaterials 20.Demgegenüber ist gemäß dem zweiten Ausführungsbeispiel das Bandmaterial 20 in der durch die Trennelemente 150-o, 150-u gebildeten Dichtebene durch ein Paar von sich gegenüberstehenden Dichtrollen 134 geführt. Die Dichtrollen 134 bilden jeweils mit der Oberseite und der Unterseite - wiederum bis auf unvermeidliche Leckagespalte 153 - eine gute Abdichtung zwischen der äußeren und der inneren Druckkammer 110, 120. Bei dem hier gezeigten Ausführungsbeispiel enden die Dichtlippen des oberen Trennelementes 150-o und des unteren Trennelementes 150-u jeweils - wiederum bis auf unvermeidliche Leckagespalte 153 - an den dem Bandmaterial 20 abgewandten Bereichen der Oberflächen der Dichtrollen 134.

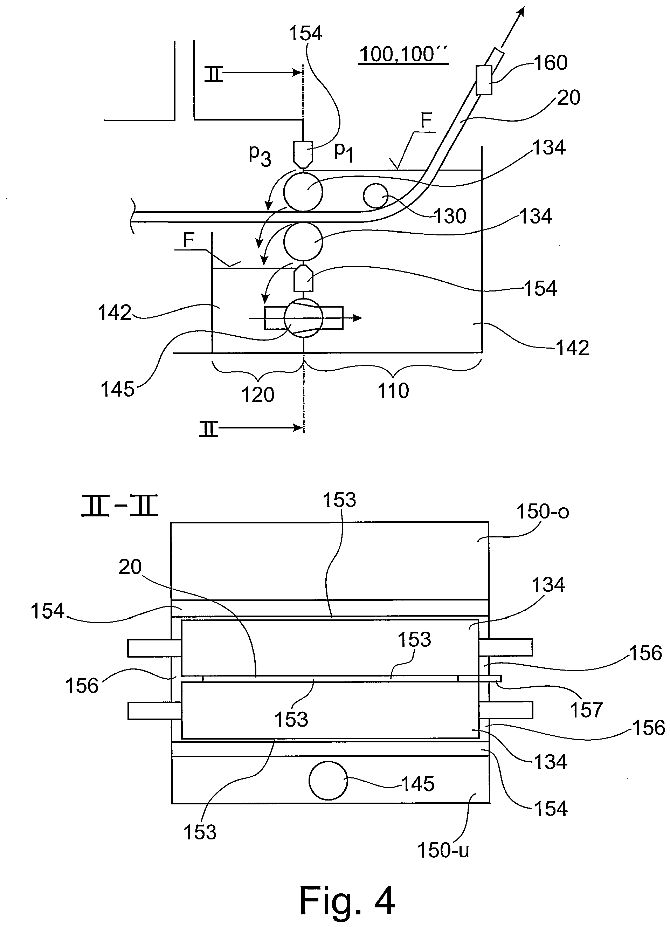

Die obere Abbildung in Figur 4 zeigt wiederum die aus Figur 3 bekannte Ausgangsschleuse 100" gemäß dem zweiten Ausführungsbeispiel. Die untere Abbildung in Figur 4 veranschaulicht die besagten Leckagespalte 153 und seitlichen Spaltbereiche, 156. Demnach können die Leckagespalte 153 jeweils ausgebildet sein zwischen dem oberen Trennelement 150-o bzw. dessen zugeordneter Dichtlippe 154 und der oberen Dichtrolle 134, zwischen dem unteren Trennelement 150-u bzw. dessen zugeordneter Dichtlippe 154 und der unteren Dichtrolle 134, zwischen der oberen Dichtrolle 134 und der Oberseite des Bandmaterial 20, zwischen der unteren Dichtrolle 134 und der Unterseite des Bandmaterials 20 sowie in den besagten seitlichen Spaltbereichen 156, bei denen es sich ebenfalls um Leckagespalte handelt.

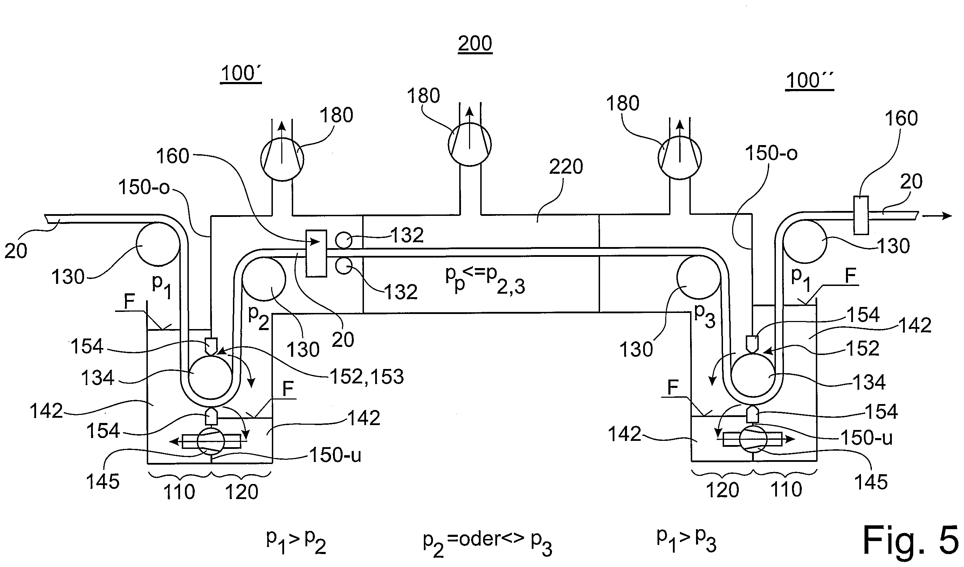

Figur 5 zeigt wiederum die erfindungsgemäße Bandanlage 200, dieses Mal jedoch mit einem dritten Ausführungsbeispiel für die erfindungsgemäße Schleusenvorrichtung 100 als Eingangs- und Ausgangsschleuse 100', 100". Bei dem dritten Ausführungsbeispiel ist die erfindungsgemäße Eingangs- und/oder Ausgangsschleuse 100', 100" in Form eines Schlingenhebers ausgebildet. In dem Fenster 152 zwischen dem oberen Trennelement 150-o und dem unteren Trennelement 150-u ist eine Dichtrolle 134 drehbar gelagert und das Bandmaterial 20 ist an der Unterseite der Dichtrolle 134 um diese umgelenkt. Der Kontaktbereich zwischen der Dichtrolle 134 und dem Bandmaterial 20 kann einen Leckagespalt für das Fluid 142 bilden. Dieser Leckagespalt ist aber aufgrund des großen Umschlingungswinkels vernachlässigbar. Die Dichtlippe 154 des oberen Trennelementes 150-o liegt vorzugsweise auf der Oberseite der Dichtrolle 134 an. Die Dichtlippe 154 des unteren Trennelementes 150-u tangiert die Unterseite des um die Dichtrolle 134 umgelenkten Bandmaterials 20. Für einen horizontalen Einlauf des Bandmaterials 20 in die äußere Druckkammer 110 und für einen horizontalen Auslauf des Bandmaterials 20 aus der inneren Druckkammer 120 sind der besagten Dichtrolle 134 eine Umlenkrolle 130 in der äußeren Druckkammer 110 vorgeschaltet und eine Umlenkrolle 130 in der inneren Druckkammer 120 der Dichtrolle 134 nachgeschaltet. Auch bei diesem dritten Ausführungsbeispiel kann der Umlenkrolle 130 in der inneren Druckkammer 120 eine Trocknungseinrichtung 160 nachgeschaltet sein zum Trocknen des Bandmaterials 20 bevor dieses in die Behandlungskammer 220 einläuft. Die in Figur 5 gezeigte Ausgangsschleuse 100" in Transportrichtung hinter der Bandbehandlungskammer 220 ist analog zu der Eingangsschleuse aufgebaut.

In den Figuren 1, 3 und 5 sind die Eingangsschleusen und Ausgangsschleusen 100', 100" immer jeweils analog ausgebildet. Dies ist jedoch keineswegs zwingend. So sind die erfindungsgemäßen drei Ausführungsbeispiele für die Schleusen als Eingangs- und Ausgangsschleusen für den Behandlungsbereich 200 beliebig miteinander kombinierbar. Auch ist es ohne weiteres möglich, eine der erfindungsgemäßen Schleusenvorrichtungen 100 als Eingangs- oder als Ausgangsschleuse zu verwenden und zusätzlich ausgangsseitig bzw. eingangsseitig der Behandlungskammer 220 eine oder mehrere Schleusenvorrichtungen eines anderen Typs, der nicht Gegenstand der vorliegenden Erfindung ist, zu verwenden, um z. B. Prozessdrücke pₚ zu erreichen, die unterhalb des Dampfdruckes der eingesetzten Flüssigkeit in den äußeren Schleusen liegen.

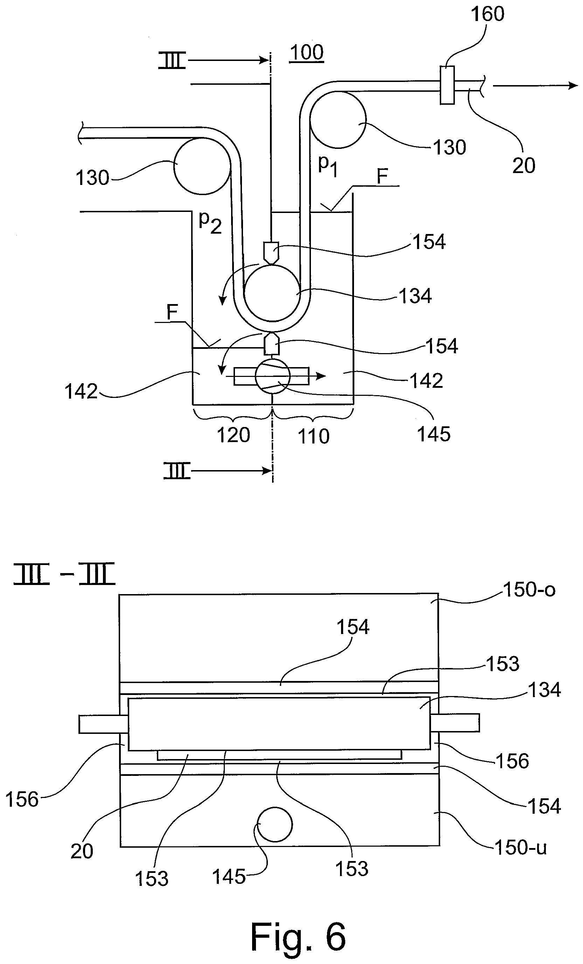

Figur 6 zeigt schließlich in seiner oberen Abbildung erneut das dritte Ausführungsbeispiel für die erfindungsgemäße Schleusenvorrichtung gemäß Figur 5 und in seiner unteren Querschnittsansicht III-III die bei dem dritten Ausführungsbeispiel unweigerlich entstehenden Leckagespalte. Es sind dies der Leckagespalt 153 zwischen dem oberen Trennelement 150-o bzw. dessen unterer Dichtlippe 154 und der Dichtrolle 134, der Leckagespalt 153 zwischen dem unteren Trennelement 150-u bzw. dessen oberer Dichtlippe 154 und der Unterseite des Metallbandes 20, der Leckagespalt 153 zwischen der Dichtrolle 134 und dem Bandmaterial 20 (aufgrund des großen Umschlingungswinkels vernachlässigbar) sowie die besagten seitlichen Spaltbereiche 156.

Die gemäß Figur 2 erläuterten Möglichkeiten zur Abdeckung der Leckagespalte gelten für die in den Figuren 4 und 6 gezeigten Leckagespalte gleichermaßen, außer jeweils für die Leckagespalte zwischen dem Bandmaterial 20 und der mindestens einen Dichtrolle 134.

Das Verfahren zum Betreiben der Schleusenvorrichtung 100 weist die folgenden Schritte auf:
- Durchleiten des Bandmaterials 20 durch die äußere und nachfolgend durch die innere Druckkammer 110, 120 - oder in umgekehrter Richtung - unter Ausbildung mindestens eines Leckagespaltes 153 zwischen dem durchgeleiteten Bandmaterial 20 und dem oberen und/oder dem unteren Trennelement 150-o, 150-u; bzw. deren Dichtlippen 154;
- Fluten der äußeren Druckkammer 110 mit einem Fluid 142 bis auf einen Füllstand F; und
- Einstellen des Innendrucks p2 in der inneren Druckkammer 120 auf einen Wert kleiner als der Wert des Außendrucks p1 in der äußeren Druckkammer 110.

Das Fluten der äußeren Druckkammer 110 erfolgt zumindest bis auf einen solchen Füllstand F, dass ein unterer Leckagespalt 153 zwischen der unteren Dichtrolle 134 und dem unteren Trennelement 150-u, zwischen der Unterseite des Bandmaterials 20 und dem unteren Trennelement 150-u, und/oder zwischen der Unterseite des Bandmaterials und der unteren Dichtrolle 134 überflutet wird. Aufgrund der Druckdifferenz zwischen dem Außendruck p1 und dem kleineren Innendruck p2, p3 fließt dann zumindest ein unterer Leckagevolumenstrom aus der äußeren Druckkammer 110 durch den unteren Leckagespalt 153 hindurch in die innere Druckkammer 120. Zumindest der untere Leckagevolumenstrom des Fluids 142 wird dann mit Hilfe der Pumpe 145 aus der inneren Druckkammer 120 durch die fluidleitende Verbindung 140 hindurch in die äußere Druckkammer 110 zurückgepumpt, sodass zumindest der untere Leckagespalt 153 und zumindest ein Teil der seitlichen Spaltbereiche 156 geflutet bleiben.

Das Fluten der äußeren Druckkammer 110 erfolgt vorzugsweise bis auf einen solchen Füllstand F, dass zusätzlich zu dem unteren Leckagespalt 153 auch der mindestens eine obere Leckagespalt überflutet wird. Aufgrund der Druckdifferenz zwischen dem Außendruck und dem kleineren Innendruck fließt dann zusätzlich zu dem unteren Leckagevolumenstrom auch ein oberer Leckagevolumenstrom aus der äußeren Druckkammer 110 durch den oberen Leckagespalt 153 hindurch in die innere Druckkammer 120. Dort sammelt sich das Fluid 142 auf einen Füllstand F. Neben dem unteren wird dann auch der obere Leckagevolumenstrom des Fluids 142 mit Hilfe der Pumpe 145 aus der inneren Druckkammer 120 durch die fluidleitende Verbindung 140 hindurch in die äußere Druckkammer 110 zurückgepumpt, sodass nicht nur der untere, sondern auch der obere Leckagespalt 153 und die kompletten seitlichen Spaltbereiche 156 geflutet bleiben.

Wenn die Schleusenvorrichtung 100 als Eingangsschleuse 100' für die Bandbehandlungskammer 200 fungiert wird das Bandmaterial 20 nach dem Durchlaufen der äußeren Druckkammer 110 innerhalb der inneren Druckkammer 120 vorzugsweise mit Hilfe einer Trocknungseinrichtung 160 getrocknet, bevor es in die Bandbehandlungskammer 220 einläuft.

Wenn die Schleusenvorrichtung 100 als Ausgangsschleuse 100" für die Bandbehandlungskammer 220 fungiert, durchläuft das Bandmaterial 20 nach dem Ausschleusen aus der äußeren Druckkammer 110 optional eine Trocknungseinrichtung 160 zum Trocknen des noch an dem Bandmaterial 20 anhaftenden Fluids 142.

Die Breite B des Bandmaterials 20 liegt zwischen 10mm und 2600mm. Die Dicke D des Bandmaterials 20 liegt zwischen 0,1mm und 10mm. Die Geschwindigkeit, mit welcher das Bandmaterial durch die beiden Druckkammern 110, 120 und die Behandlungskammer 220 hindurchgeleitet wird, liegt zwischen 1m/min und 500m/min.

Bei dem Fluid 142 kann es sich um Wasser oder eine wässrige Lösung oder um eine Flüssigkeit mit einem niedrigeren Dampfdruck als Wasser handeln, z.B. Quecksilber oder Gallium.

Der Außendruck p1 in der äußeren Druckkammer der Eingangsschleuse ist typischerweise größer als der Innendruck p2 in der inneren Druckkammer der Eingangsschleuse 100` und der Außendruck p1 in der äußeren Druckkammer der Ausgangsschleuse 100" ist typischerweise größer als der Innendruck p3 in der inneren Druckkammer 120 der Ausgangsschleuse 100". Vorzugsweise sind die Außendrücke p1 in der äußeren Druckkammer 110 der Eingangsschleuse 100' und in der äußeren Druckkammer 110 der Ausgangsschleuse 100" jeweils gleich groß, weiter vorzugsweise entsprechen sie jeweils dem Atmosphärendruck.

Der Innendruck p2 in der inneren Druckkammer 120 der Eingangsschleuse 100' kann größer, kleiner oder gleich dem Innendruck p3 in der inneren Druckkammer 120 der Ausgangsschleuse 100" sein.

### Bezugszeichenliste

- 100: Schleusenvorrichtung
- 100`: Eingangsschleuse
- 100": Ausgangsschleuse
- 110: äußere Druckkammer
- 120: innere Druckkammer
- 130: Umlenkrolle
- 132: Führungsrolle, Führungsrollenpaar
- 134: Dichtrolle, Dichtrollenpaar
- 140: fluidleitende Verbindung
- 142: Fluid
- 145: Fluidpumpe
- 148: Bypass
- 150-o: oberes Trennelement
- 150-u: unteres Trennelement
- 152: Fenster
- 153: Leckagespalt
- 154: elastische Dichtlippe
- 156: seitlicher Spaltbereich
- 157: verstellbare Blenden
- 160: Trocknungseinrichtung
- 180: Vakuumpumpe
- 20: Bandmaterial
- 200: Behandlungsanlage
- 220: Behandlungskammer
- 240: weitere Schleuse
- →: Transportrichtung Bandmaterial
- ↶↷: Leckagepfeile

- B: Breite
- D: Dicke
- F: Füllstand des Fluids
- p1: Außendruck
- p2: Innendruck
- p3: Innendruck
- pₚ: Innendruck
- I-I: Querschnittsansicht
- II-II: Querschnittsansicht
- III-III: Querschnittsansicht

## Patentansprüche

1. Schleusenvorrichtung (100) zum Ein- oder Ausschleusen von Bandmaterial (20) in eine Bandbehandlungskammer (200) , aufweisend:
eine äußere Druckkammer (110) für einen Außendruck (p1) und eine innere Druckkammer (120) für einen Innendruck (p2), jeweils zum Durchleiten des Bandmaterials (20), wobei der Außendruck (p1) größer ist als der Innendruck (p2), und wobei beide Druckkammern (110, 120) ausgebildet sind zur Aufnahme eines Fluids (142);
eine Vakuumpumpe (180) zum Einstellen des Innendruckes (p2) in der inneren Druckkammer (120);
eine fluidleitende Verbindung (140) zum Leiten des Fluids (142) zwischen der äußeren und der inneren Druckkammer (110, 120); und
ein oberes Trennelement (150-o) zum Trennen der äußeren von der inneren Druckkammer;
**dadurch gekennzeichnet,**
**dass** ein unteres Trennelement (150-u) vorgesehen ist zum Trennen der äußeren von der inneren Druckkammer (110, 120);
**dass** zwischen dem oberen und dem unteren Trennelement (150-o, 150-u) ein Fenster (152) ausgebildet ist zum Durchleiten des Bandmaterials (20); und
**dass** in der fluidleitenden Verbindung (140) eine Fluidpumpe (145) eingebaut ist zum Pumpen von zumindest Teilen des Fluids (142) von der inneren Druckkammer (120) durch die fluidleitende Verbindung (140) zurück in die äußere Druckkammer (110).

2. Schleusenvorrichtung (100) nach Anspruch 1,
**dadurch gekennzeichnet,**
**dass** die fluidleitende Verbindung (140) in Form einer Öffnung oder eines Kanalabschnitts in dem unteren Trennelement (150-u) ausgebildet ist.

3. Schleusenvorrichtung (100) nach einem der vorangegangenen Ansprüche, **dadurch gekennzeichnet,**
**dass** die fluidleitende Verbindung (140) in Form eines Bypasses (148) außerhalb der beiden Druckkammern (110, 120) verlaufend ausgebildet ist.

4. Schleusenvorrichtung (100) nach einem der vorangegangenen Ansprüche, **dadurch gekennzeichnet,**
**dass** in der Schleusenvorrichtung (100) mindestens eine drehbar gelagerte Rolle (130) vorgesehen ist, die als Umlenkrolle fungiert zum Umlenken des Bandmaterials innerhalb einer der beiden Druckkammern (110, 120).

5. Schleusenvorrichtung (100) nach einem der vorangegangenen Ansprüche, **dadurch gekennzeichnet,**
**dass** in dem Fenster (152) zwischen den beiden Trennelementen (150-o, 150-u) ein Dichtrollenpaar mit zwei sich gegenüberstehenden drehbar gelagerten Dichtrollen (134) vorgesehen ist, die einen Rollenspalt aufspannen, zum Durchleiten und Stabilisieren des Bandmaterials (20); oder
**dass** in dem Fenster (152) zwischen den beiden Trennelementen (150-o, 150-u) eine einzelne Dichtrolle (134) vorgesehen ist, die mit dem unteren Trennelement (150-u) einen Spalt aufspannt zum Durchleiten und Stabilisieren des Bandmaterials (20).

6. Schleusenvorrichtung (100) nach Anspruch 5,
**dadurch gekennzeichnet,**
**dass** das obere Trennelement und/oder das untere Trennelement (150-u, 150-o) mit seinem rollenseitigen Ende an der Dichtrolle (134) endet bis auf einen Leckagespalt (153).

7. Schleusenvorrichtung (100) nach einem der vorangegangenen Ansprüche, **dadurch gekennzeichnet,**
**dass** an dem rollenseitigen oder bandmaterialseitigen Ende des oberen und/oder des unteren Trennelementes (150-o, 150-u) eine vorzugsweise elastische Dichtlippe (154) angeordnet ist zum dichtenden Kontaktieren der Dichtrolle (134) oder des Bandmaterials (20) bis auf einen Leckagespalt (153).

8. Schleusenvorrichtung (100) nach einem der vorangegangenen Ansprüche, **dadurch gekennzeichnet,**
**dass** das obere und/oder das untere Trennelement (150-o, 150-u) über der gesamten Breite der beiden Druckkammern (110, 120) ausgebildet ist, auch in den seitlichen Spaltbereichen (156) zwischen den Stirnseiten der Rolle (130) und den Wänden der Druckkammern, die die Druckkammern in Breitenrichtung begrenzen, und/ oder zwischen den Schmalseiten des Bandes (20) und den Wänden der Druckkammern; oder
**dass** - wenn die Trennelemente (150-o, 150-u) nicht auch die seitlichen Spaltbereiche (156) abdecken - zusätzlich zu dem oberen und unteren Trennelement (150-o, 150-u) vorzugsweise verstellbare Blenden (157) vorgesehen sind zum Reduzieren der seitlichen Spaltbereiche (156).

9. Schleusenvorrichtung (100) nach einem der vorangegangenen Ansprüche, **dadurch gekennzeichnet,**
**dass** das obere und das untere Trennelement (150-o, 150-u) mit dem Fenster (152) einstückig ausgebildet sind.

10. Schleusenvorrichtung (100) nach einem der vorangegangenen Ansprüche, **dadurch gekennzeichnet,**
**dass** der Öffnungsquerschnitt des Fensters (152) - bis auf Leckagespalte (153) - gleich dem Querschnitt des durchzuleitenden Bandmaterials (20) oder gleich der Summe der Querschnitte von der mindestens einen Dichtrolle (134) und von dem die Dichtrolle bei Durchleitung durch das Fenster (100) kontaktierenden Bandmaterial (20) ist.

11. Schleusenvorrichtung (100) nach einem der vorangegangenen Ansprüche, **gekennzeichnet durch**
eine Trocknungseinrichtung (160) zum Trocknen des Bandmaterials (20) in der inneren Druckkammer (120) der Eingangsschleuse (100') vor seinem Einlauf in die Behandlungskammer (220) und/oder innerhalb oder außerhalb der äußeren Druckkammer (110) der Ausgangsschleuse (100") nach Verlassen des Fluids in der Ausgangsschleuse (100").

12. Verfahren zum Betreiben der Schleusenvorrichtung (100) nach einem der vorangegangenen Ansprüche, aufweisend die folgenden Schritte:
- Durchleiten des Bandmaterials (20) durch die äußere und nachfolgend durch die innere Druckkammer (110, 120) - oder in umgekehrter Richtung - unter Ausbildung mindestens eines oberen Leckagespaltes zwischen der Rolle (130) und/oder der Oberseite des durchgeleiteten Bandmaterials (20) und dem oberen Trennelement (150-o) bzw. dessen zugeordneter Dichtlippe (154);
- Fluten der äußeren Druckkammer (110) mit einem Fluid (142); und
- Einstellen des Innendrucks (P2) in der inneren Druckkammer (120) auf einen Wert kleiner als der Wert des Außendrucks (P1) in der äußeren Druckkammer (110) ;
**dadurch gekennzeichnet,**
**dass** das Fluten der äußeren Druckkammer (110) zumindest soweit erfolgt, dass ein unterer Leckagespalt (153) zwischen der Rolle (130) und/oder der Unterseite des Bandmaterials (20) und dem unteren Trennelement (150-u) bzw. dessen zugeordnete Dichtlippe (154) überflutet wird,
**dass** aufgrund der Druckdifferenz zwischen dem Außendruck und dem kleineren Innendruck ein unterer Leckagevolumenstrom aus der äußeren Druckkammer (110) durch den unteren Leckagespalt (153) hindurch in die innere Druckkammer (120) fließt; und
**dass** zumindest der untere Leckagevolumenstrom des Fluids (142) mit Hilfe der Fluidpumpe (145) aus der inneren Druckkammer (120) durch die fluidleitende Verbindung (140) hindurch in die äußere Druckkammer (110) zurückgepumpt wird, sodass zumindest der untere Leckagespalt (152) auf der Seite der äußeren Druckkammer (110) geflutet bleibt.

13. Verfahren nach Anspruch 12,
**dadurch gekennzeichnet,**
**dass** das Fluten der äußeren Druckkammer (110) zumindest soweit erfolgt, dass zusätzlich zu dem unteren Leckagespalt (153) auch der obere Leckagespalt (153) überflutet wird;
**dass** aufgrund der Druckdifferenz zwischen dem Außendruck (p1) und dem kleineren Innendruck (p2, p3) zusätzlich zu dem unteren Leckagevolumenstrom auch ein oberer Leckagevolumenstrom aus der äußeren Druckkammer (110) durch den oberen Leckagespalt (153) hindurch in die innere Druckkammer (120) fließt; und
**dass** neben dem unteren auch der obere Leckagevolumenstrom des Fluids (142) mit Hilfe der Fluidpumpe (145) aus der inneren Druckkammer (120) durch die fluidleitende Verbindung (140) hindurch in die äußere Druckkammer (110) zurückgepumpt wird, sodass nicht nur der untere, sondern auch der obere Leckagespalt (152) auf Seite der äußeren Druckkammer (110) geflutet bleiben.

14. Verfahren nach Anspruch 12 oder 13,
**dadurch gekennzeichnet,**
**dass** - wenn die Schleusenvorrichtung (100) als Eingangsschleuse (100') für die Bandbehandlungskammer (200) fungiert - das Bandmaterial (20) zunächst die äußere Druckkammer (110) und nachfolgend die innere Druckkammer (120) durchläuft; oder
**dass** - wenn die Schleusenvorrichtung (100) als Ausgangsschleuse (100") für die Bandbehandlungskammer (200) fungiert - das Bandmaterial (20) zunächst die innere Druckkammer (110) und nachfolgend die äußere Druckkammer (120) durchläuft.

15. Verfahren nach Anspruch 14,
**dadurch gekennzeichnet,**
**dass** - wenn die Schleusenvorrichtung (100) als Eingangsschleuse (100') für die Bandbehandlungskammer (200) fungiert - das Bandmaterial (20) nach dem Durchlaufen der äußeren Druckkammer (110) innerhalb der inneren Druckkammer (120) eine Trocknungseinrichtung (160) durchläuft zum Trocknen des noch aus der äußeren Druckkammer (110) an dem Bandmaterial (20) anhaftenden Fluids (142), vor dem Einlaufen in die Bandbehandlungskammer (220).

16. Verfahren nach Anspruch 14 oder 15,
**dadurch gekennzeichnet,**
**dass** - wenn die Schleusenvorrichtung (100) als Ausgangsschleuse (100") für die Bandbehandlungskammer (220) fungiert - das Bandmaterial (20) nach seinem Austritt aus dem Fluid (142) inder äußeren Druckkammer (110) eine Trocknungseinrichtung (160) durchläuft zum Trocknen des noch an dem Bandmaterial (20) anhaftenden Fluids (142).

17. Verfahren nach einem der Ansprüche 12 bis 16,
**dadurch gekennzeichnet,**
**dass** die Breite (B) des Bandmaterials (20) zwischen 10mm und 2600mm liegt;
**dass** die Dicke (D) des Bandmaterials (20) zwischen 0,1mm und 10mm liegt; und/oder
**dass** die Geschwindigkeit mit welcher das Bandmaterial (20) durch die beiden Druckkammern (110, 120) hindurchgeleitet wird zwischen 1m/min und 500m/min liegt.

18. Verfahren nach einem der Ansprüche 12 bis 17,
**dadurch gekennzeichnet,**
**dass** es sich bei dem Fluid (142) um Wasser oder eine wässrige Lösung oder um eine Flüssigkeit mit einem niedrigeren Dampfdruck als Wasser handelt, z.B. Quecksilber oder Gallium.

19. Bandbehandlungsanlage (200) aufweisend:
eine Bandbehandlungskammer (220) zum Behandeln von Bandmaterial (20);
eine Eingangsschleuse (100') zum Einschleusen des Bandmaterials (20) in die Bandbehandlungskammer (220); und
eine Ausgangsschleuse (100") zum Ausschleusen des Bandmaterials (20) aus der Bandbehandlungskammer (220);
**dadurch gekennzeichnet,**
**dass** die Eingangsschleuse (100') und/oder die Ausgangsschleuse (100") ausgebildet ist gemäß der Schleusenvorrichtung (100) nach einem der Ansprüche 1 bis 11.

20. Bandbehandlungsanlage (200) nach Anspruch 19,
**dadurch gekennzeichnet,**
**dass** es sich bei der Bandbehandlungskammer (200) um die innere Druckkammer (120) der Eingangsschleuse (100') und/oder um die innere Druckkammer (120) der Ausgangsschleuse (100"); oder
**dass** es sich bei der Bandbehandlungskammer (200) um eine separate Druckkammer handelt, die eingangsseitig von der inneren Druckkammer (120) der Eingangsschleuse (100') und ausgangsseitig von der inneren Druckkammer (120) der Ausgangsschleuse (100"), jeweils durch zusätzliche Schleusen (240) getrennt ist.

21. Behandlungsanlage (200) nach Anspruch 19 oder 20,
**gekennzeichnet durch**
eine Trocknungseinrichtung (160) in der inneren Druckkammer (120) der Eingangsschleuse (100'), und/oder hinter der äußeren Druckkammer (110) der Ausgangsschleuse (100") zum Trocknen des durchlaufenden Bandmaterials (20).

22. Verfahren zum Betreiben der Bandbehandlungsanlage nach einem der Ansprüche 19 bis 21,
**dadurch gekennzeichnet,**
**dass** der Außendruck (p1) in der äußeren Druckkammer (110) der Eingangsschleuse (100') größer ist als der Innendruck (p2) in der inneren Druckkammer (120) der Eingangsschleuse (100'); und
**dass** der Außendruck (p1) in der äußeren Druckkammer (110) der Ausgangsschleuse (100") größer ist als der Innendruck (p3) in der inneren Druckkammer (120) der Ausgangsschleuse (100"); und
**dass** vorzugsweise die Außendrücke (p1) in der äußeren Druckkammer (110) der Eingangsschleuse (100') und in der äußeren Druckkammer (110) der Ausgangsschleuse (100") jeweils gleich groß sind, weiter vorzugsweise jeweils dem Atmosphärendruck entsprechen.

23. Verfahren zum Betreiben der Bandbehandlungsanlage nach Anspruch 22, **dadurch gekennzeichnet,**
**dass** der Druck (pₚ) in der Bandbehandlungskammer (220) kleiner oder gleich dem Innendruck (p2) in der inneren Druckkammer (120) der Eingangsschleuse (100') und/oder dem Innendruck (p3) in der inneren Druckkammer (120) der Ausgangsschleuse (100") ist.

24. Verfahren nach einem der Ansprüche 22 oder 23,
**dadurch gekennzeichnet,**
**dass** der Innendruck (p2) in der inneren Druckkammer (120) der Eingangsschleuse (100') größer, kleiner oder gleich dem Innendruck (p3) in der inneren Druckkammer (120) der Ausgangsschleuse (100") ist.

25. Verfahren nach einem der Ansprüche 22 bis 24
**dadurch gekennzeichnet,**
**dass** das Bandmaterial (20) in der inneren Druckkammer (120) der Eingangsschleuse (100') und/oder in oder hinter der äußeren Druckkammer der Ausgangsschleuse (100") getrocknet wird, nachdem es jeweils aus dem Fluid (142) in einer der äußeren Druckkammern (110) ausgelaufen ist.
